# EUROPEAN PATENT SPECIFICATION

(11) **EP 0 969 699 B1**
(45) Date of publication and mention of the grant of the patent: **22.01.2003**
(21) Application number: 99112509.7
(22) Date of filing: 01.07.1999
(51) Int. Cl.: H05B 33/02, H05B 33/12

(54) **Light-emitting device based on an electroluminescent organic material, having a shaped outer interface**
Lichtausstrahlende organische Elektrolumineszensvorrichtung mit einer geformten, ausserhalb liegenden Zwischenfläche
Dispositif organique électroluminescent émettant de la lumière ayant à l'extérieur de l' interface un façonnage

(30) Priority: 02.07.1998 IT TO980580
(43) Date of publication of application: 05.01.2000
(73) Proprietor: C.R.F. Società Consortile per Azioni, 10043 Orbassano (Torino) (IT)
(72) Inventor: Perlo, Piero, c/o C.R.F. Soc. Consortile per A., 10043 Orbassano (Torino) (IT); Repetto Piermario c/o C.R.F. Soc. Consortile per A, 10043 Orbassano (Torino) (IT); Bigliati, Claudia, C.R.F. Soc. Consortile per A., 10043 Orbassano (Torino) (IT); Farina, Silvia, C.R.F. Soc. Consortile per Azioni, 10043 Orbassano (Torino) (IT); Negri, Alessandro, C.R.F. Soc. Consortile per A., 10043 Orbassano (Torino) (IT)
(74) Representative: Notaro, Giancarlo

(56) References cited:
- WO-A-92/14173
- WO-A-96/36201
- WO-A-98/57525
- DATABASE WPI Section PQ, Week 9718 Derwent Publications Ltd., London, GB; Class P81, AN 97-198425 XP002116335 & JP 09 054171 A (CITIZEN WATCH CO LTD), 25 February 1997 (1997-02-25)
- PATENT ABSTRACTS OF JAPAN vol. 097, no. 009, 30 September 1997 (1997-09-30) & JP 09 115667 A (SONY CORP), 2 May 1997 (1997-05-02)
- PATENT ABSTRACTS OF JAPAN vol. 098, no. 004, 31 March 1998 (1998-03-31) & JP 09 326297 A (CASIO COMPUT CO LTD), 16 December 1997 (1997-12-16)
- DATABASE WPI Section PQ, Week 9713 Derwent Publications Ltd., London, GB; Class P81, AN 97-136304 XP002116336 & JP 09 015596 A (SEIKOSHA KK), 17 January 1997 (1997-01-17)

## Description

The present invention relates to light-emitting devices based on an organic luminescent material of the so called LEP (Light-Emitting Polymers) type or OLED (Organic Light-Emitting Devices) type. Devices of this type have been described for example in "High-External Quantum-Efficiency Organic Light-Emitting Devices", Garbuzov et al., OPTICS LETTERS, vol. 22, n. 6, March 15 1997.

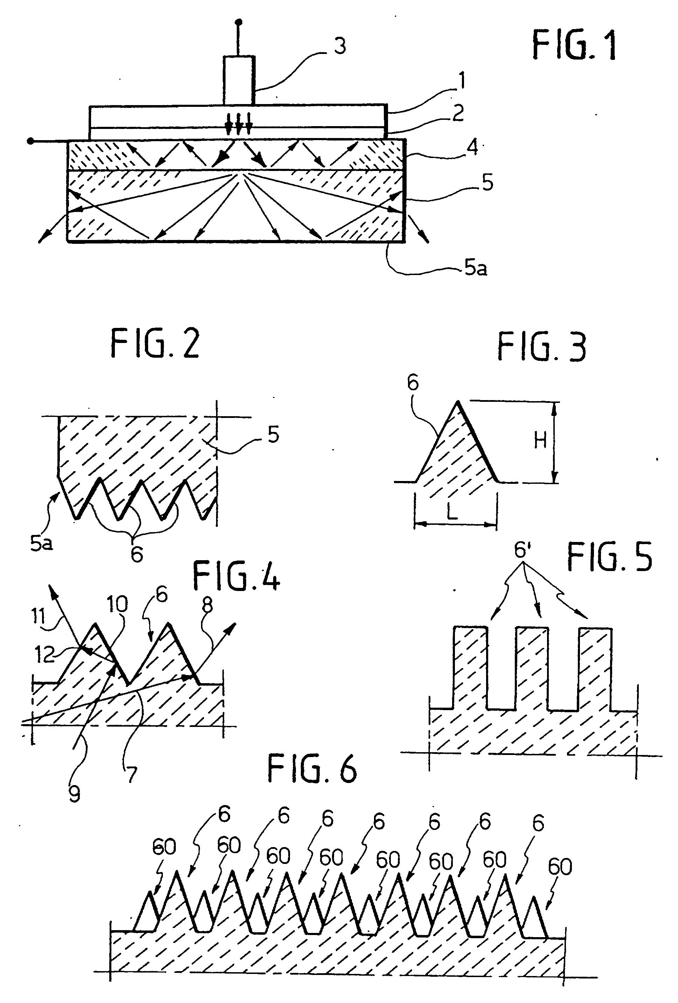

The devices of the above indicated type (see figure 1 of the annexed drawings) commonly have a first layer 1 of electroluminescent material, such as Alq₃, for example having a thickness of 80nm, and a second layer 2 of the same thickness made of a material such as N,N'-diphnil-N,N'-bis(3-methylphenil) 1-1'biphenil-4,4'diamine (TPD). At the back of layer 1 there is applied an electrode 3, whereas on the front the layer 2 is covered by a transparent plate 4 acting as electrode, typically made of ITO (Indium Tin Oxide), having a thickness of about 150nm. The above described structure is then covered by a substrate plate 5, such as of glass, having a thickness for example of 1.1nm.

The light-emitting devices of the above indicated type have a very high efficiency, but have the drawback that only a small portion of the generated light (generally in the order of 20-30% at most) is able to get out of the device, the larger remaining portion being instead wasted through a sequence of reflections inside the transparent plates, due to a wave guide effect. The light flow at the output is generally proportional to the current supplied to the two electrodes of the device, so that one can try to overcome the above mentioned drawback by increasing the current being supplied. However, in this manner the average life of the device is substantially reduced.

The above indicated publication discloses a tentative solution to the above mentioned problem in which the structure of the device has a substrate shaped so as to define a plurality of emitting sources located at apices of pyramids or cones having reflective lateral surfaces which reflect the rays emitted by the source at a large divergence angle so as to cause these rays to get out from the front of the device, thus avoiding the wave guide effect which has been described above. However, the solution has the drawback of having a relatively complicated and costly structure.

The object of the present invention is that of providing a simple and efficient solution to the problem which has been indicated in the foregoing.

In view of achieving this object, the invention provides a light-emitting device based on an organic material, comprising at least one emitting source including at least one layer of electroluminescent organic material, a transparent layer of ITO (Indium Tin Oxide) acting as electrode located over the layer of electroluminescent material and a transparent substrate plate, for example made of glass or plastic material, located over the transparent electrode, as well as an electrode applied at the back of the layer of electroluminescent material and means for applying an electric voltage to said electrodes, so as to cause the emission of light from the layer of electroluminescent material, characterized in that at least one of the two surfaces of said substrate plate is shaped with a plurality of micro-projections arranged in a matrix and in that there are provided two series of microprojections (6, 60), the projections of the first series (6) having a height which is substantially greater than the height of the microprojections of the second series (60).

According to a further preferred feature, also one or more of the other layers of the device have one or both of their surfaces similarly shaped.

Each micron projection may have a conical or pyramidal or prismatic shape and has a height/transverse dimension ratio not lower than 1. The height of the projections is for example chosen between 0.01mm and 0.1mm.

Due to the above indicated features, the light rays which are emitted by the device at a large divergence angle meet the surfaces of the micro-projections at an angle which is lower than that which would occur if the surface of the glass plate were planar, so that these rays are not reflected inside the glass plate, but rather are transmitted to the outside. Instead, as far as the rays having a small incidence angle are concerned, they are reflected a first time on the surface of a micro-projection to be then recovered and directed to the outside at the other surface of the micro-projection which is subsequently met.

Due to the above indicated features, the quantity of light which is transmitted to the outside by the device is very relevant and may arrive to be in the order of 80% of the total emitted light.

As indicated, two series of uniformly distributed micro-projections are provided, the projections of the first series having a height substantially greater than the projections of the second series, in order to obtain the best characteristics for the emitted beam. Further features and advantages of the invention will become apparent from the following description with reference to the annexed drawings, given purely by way of non limiting example, in which:
figure 1, which has been already described, shows a light-emitting device according to the prior art,
figures 2-4, shows a detail of figure 1 at an enlarged scale, in order to explain the principle at the basis of the present invention,
figure 5 shows a variant of figure 2, and
figure 6 shows an embodiment of the invention, and
figure 7 diagrammatically shows a further variant.

With reference to figure 2, according to the embodiment shown, the surface of outer interface 5a of the substrate plate 5 is shaped with a plurality of micro-projections 6 having a conical or pyramidal shape, arranged in a matrix. Alternatively, the micro-projections can be located on the opposite face or also on both faces. The plate 5 can also be of plastic (rigid or flexible) material, such as PET or OCLAR. In the case of use of a porous plastic material, a protective layer can be applied, such as of silicon oxide, in order to isolate the device from the outside environment. In the case that both faces of plate 5 are shaped with micro-projections, the two profiles of these faces can be out-of-phase relative to each other in order to render a further parameter available in order to improve the quantity of extracted light. The micro-projections 6 (figure 3) have a H/width L ratio (H/L) not lower than 1. Due to this feature, the light rays emitted by the source at a large incidence angle (such as the ray designated by 7 in figure 4) are not reflected inside the plate 5 (as it would instead occur if they met a planar surface) because they encounter the lateral surface of the micro-projections at a small incidence angle. The ray 7 is therefore transmitted to the outside in form of a ray 8. The rays of the type designated by 9 in figure 4, which are emitted by the source at a small incidence angle are reflected inside the plate after that they have met the lateral surface of a micro-projection at 10 at a first time, but are then recovered and transmitted to the outside in form of a ray 11 after that they have met the other lateral surface of the micro-projection at 12 at a second time. Therefore, the quantity of light emitted to the outside by the device is substantially increased with respect to what happens in the case of the device shown in figure 1 having a planar outer interface 5a.

In a preferred embodiment, the height of the pyramidal micro-projection is in the order of 0.01-0.1mm, for example 0.02mm and the horizontal dimension is in the order of 0.015 micrometers.

Figure 6 shows the embodiment according to the invention which has two series of microprojections 6, 60 which are alternated to each other and uniformly distributed in a matrix, with microprojections 60 of the second series having a substantially lower height than the height of microprojections 6 of the first series. By this arrangement, a light beam having best characteristics can be obtained at the output.

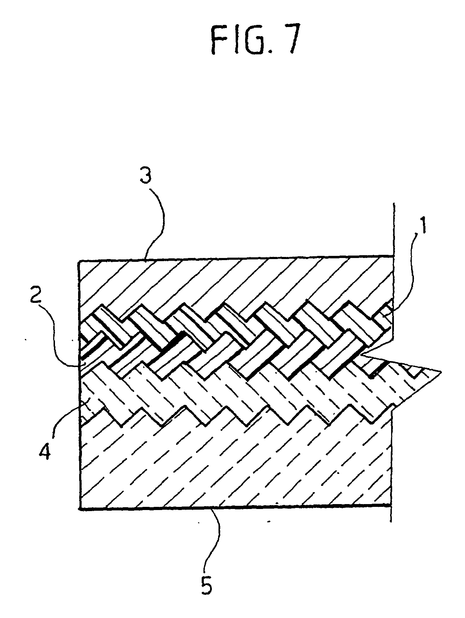

Figure 5 shows a variant in which the microprojections (designated by 6') have a binary shape with a subwavelength structure under wavelength. In this case in the preferred embodiment the microprojections have a height between 0.15 and 0.25 micrometer and a period of 0.5-0.7 micrometers with a filling factor of 0.5.
According to a further preferred feature, also one or more of the other layers of the device, apart from layer 5, have one or both surfaces shaped in a similar way (see figure 7).

## Claims

1. Light emitting device based on an organic material, comprising at least one emitting source, including at least one layer (1, 2) of electroluminescent organic material, one transparent layer (4) of ITO (Indium Tin Oxide), which is used as an electrode, located over the layer of electroluminescent material (1, 2), a transparent substrate plate (5), located over the transparent electrode (4), an electrode (3) applied at the back of the layer of electroluminescent material (1, 2) and means for applying an electric voltage to said electrodes, so as to cause the emission of light by the layer of electroluminescent material, **characterized in that** at least one of the two surfaces (5a) of said substrate plate is shaped with a plurality of microprojections (6) arranged in a matrix and - **in that** there are provided two series of microprojections (6, 60), alternate to each other and uniformly distributed in the matrix the projections of the first series (6) having a height which is substantially greater than the height of the microprojections of the second series (60).

2. Device according to claim 1, **characterized in that** said microprojections (6) have a conical or pyramidal or prismatic shape.

3. Device according to claim 1, **characterized in that** each microprojection (6) has a height/width ratio (H/L) not lower than 1.

4. Device according to claim 1, **characterized in that** the microprojections are of subwavelength binary type, preferably with a height between 0.15 and 0.25 micrometers, period of 0.5 to 0.7 micrometers and filling factor of 0.5, said values being chosen as a function of the emitted wavelength.

5. Device according to claim 1, **characterized in that** said substrate plate (5) is made of glass.

6. Device according to claim 1, **characterized in that** said substrate plate (5) is of plastic (rigid or flexible) material, such as PET, preferably provided with a protective layer, such as silicon oxide.

7. Device according to claim 1, **characterized in that** apart from said substrate plate (5), also further layers of said device have one or both faces shaped as said substrate plate (5).

## Patentansprüche

1. Lichtausstrahlende Vorrichtung, basierend auf einem organischen Material, die zumindest eine Strahlungsquelle mit zumindest einer Schicht (1, 2) aus elektrolumineszentem organischen Material, eine durchsichtige Schicht (4) aus ITO (Indium-Zinn-Oxyd), welche als eine Elektrode benutzt wird, die über der Schicht elektrolumineszenten Materials (1, 2) angeordnet ist, eine durchsichtige Substratplatte (5), die über der durchsichtigen Elektrode (4) angeordnet ist, eine Elektrode (3), die auf die Rückseite der Schicht elektrolumineszenten Materials (1, 2) aufgebracht ist, sowie ein Mittel zum Anlegen einer elektrischen Spannung an die genannten Elektroden aufweist, um die Aussendung von Licht durch die Schicht elektrolumineszenten Materials zu bewirken, **dadurch gekennzeichnet, dass** zumindest eine der zwei Oberflächen (5a) der genannten Substratplatte mit einer Mehrzahl von Mikrovorsprüngen (6) gestaltet ist, die in einer Matrix angeordnet sind, und dass zwei Reihen von Mikrovorsprüngen (6, 60) vorgesehen sind, die zueinander abwechselnd und in der Matrix gleichmäßig verteilt sind, wobei die Vorsprünge der ersten Reihe (6) eine Höhe besitzen, die wesentlich größer ist als die Höhe der Mikrovorsprünge der zweiten Reihe (60).

2. Vorrichtung nach Anspruch 1, **dadurch gekennzeichnet, dass** die genannten Mikrovorsprünge (6) eine konische oder pyramidenförmige oder prismatische Form besitzen.

3. Vorrichtung nach Anspruch 1, **dadurch gekennzeichnet, dass** jeder Mikrovorsprung (6) ein Höhe/Breite Verhältnis (H/L) von nicht weniger als 1 besitzt.

4. Vorrichtung nach Anspruch 1, **dadurch gekennzeichnet, dass** die Mikrovorsprünge vom binären Teilwellenlängentyp sind, vorzugsweise mit einer Höhe zwischen 0,15 und 0,25 Mikrometer, einer Periode von 0,5 bis 0,7 Mikrometer und einem Füllfaktor von 0,5, wobei besagte Werte als Funktion des ausgestrahlten Wellenlänge gewählt sind.

5. Vorrichtung nach Anspruch 1, **dadurch gekennzeichnet, dass** die genannte Substratplatte (5) aus Glas hergestellt ist.

6. Vorrichtung nach Anspruch 1, **dadurch gekennzeichnet, dass** die genannte Substratplatte (5) aus einem (starren oder flexiblen) Kunststoffmaterial besteht, beispielsweise PET, vorzugsweise versehen mit einer Schutzschicht wie Siliziumoxyd.

7. Vorrichtung nach Anspruch 1, **dadurch gekennzeichnet, dass** abgesehen von der genannten Substratplatte (5) auch weitere Schichten der genannten Vorrichtung an einer oder beiden Seiten so geformt sind wie die genannte Substratplatte (5).

## Revendications

1. Dispositif d'émission de lumière basé sur une matière organique, comprenant au moins une source d'émission, qui comporte au moins une couche (1, 2) de matière organique électroluminescente, une couche transparente (4) d'oxyde d'étain dopé à l'indium, ou ITO, qui est utilisée comme électrode, placée au-dessus de la couche de matière électroluminescente (1, 2), une plaque formant substrat transparente (5), placée sur l'électrode transparente (4), une électrode (3) appliquée au dos de la couche de matière électroluminescente (1, 2) et un moyen servant à appliquer une tension électrique auxdites électrodes de façon à provoquer l'émission de lumière par la couche de matière électroluminescente, **caractérisé en ce qu'**au moins une des deux surfaces (5a) de ladite plaque formant substrat est conformée au moyen d'une pluralité de micro-parties saillantes (6) disposées suivant une matrice et **en ce que** sont prévues deux séries de micro-parties saillantes (6, 60) en alternance l'une avec l'autre et uniformément réparties dans la matrice, les parties saillantes de la première série (6) ayant une hauteur qui est sensiblement supérieure à la hauteur des micro-parties saillantes de la deuxième série (60).

2. Dispositif selon la revendication 1, **caractérisé en ce que** lesdites micro-parties saillantes (6) ont une forme conique, pyramidale ou prismatique.

3. Dispositif selon la revendication 1, **caractérisé en ce que** chaque micro-parties saillantes (6) présente un rapport hauteur/largeur (H/L) qui n'est pas inférieur à 1.

4. Dispositif selon la revendication 1, **caractérisé en ce que** les micro-parties saillantes sont du type à forme binaire et à structure dont l'ordre est inférieur à la longueur d'onde, avec, de préférence, une hauteur comprise entre 0,15 et 0,25 µm, une période de 0,5 à 0,7 µm et un facteur de remplissage de 0,5, lesdites valeurs étant choisies en fonction de la longueur d'onde émise.

5. Dispositif selon la revendication 1, **caractérisé en ce que** ladite plaque formant substrat (5) est faite de verre.

6. Dispositif selon la revendication 1, **caractérisé en ce que** ladite plaque formant substrat (5) est faite d'une matière plastique (souple ou rigide), comme le PET, de préférence dotée d'une couche protectrice, par exemple de l'oxyde de silicium.

7. Dispositif selon la revendication 1, **caractérisé en ce que**, en dehors de ladite plaque formant substrat (5), il existe aussi d'autres couches dudit dispositif qui ont une face ou les deux faces conformées comme ladite plaque formant substrat (5).
